# EUROPÄISCHE PATENTANMELDUNG

(11) **EP 2 259 380 A1**
(43) Veröffentlichungstag der Anmeldung: **08.12.2010**
(21) Anmeldenummer: 10160447.8
(22) Anmeldetag: 20.04.2010
(51) Int. Cl.: H01R 4/01, H05K 3/30, F16B 1/00

(54) **Verbindungsanordnung und Verfahren zum Herstellen einer Verbindungsanordnung**

(30) Priorität: 02.06.2009 DE 102009026642
(71) Anmelder: Robert Bosch GmbH, 70442 Stuttgart (DE)
(72) Erfinder: Guenter, Friedhelm, 71672, Marbach (DE); Mannal, Helmut, 70825, Korntal-Muenchingen (DE); Fix, Andreas, 70435, Stuttgart (DE)

(57) **Zusammenfassung**

Eine Verbindungsanordnung (10; 30; 40), besteht aus einem ersten Bauelement (11; 31; 41) und einem zweiten Bauelement (12; 36; 46), wobei wenigstens eines der Bauelemente (11, 12; 31, 36; 41, 46) zumindest teilweise aus einer Formgedächtnis-Legierung besteht und wobei zwischen den beiden Bauelementen (11, 12; 31, 36; 41, 46) eine kraft- bzw. formschlüssige Verbindung ausgebildet ist. Erfindungsgemäß ist vorgesehen, dass eines der Bauelemente (11, 12; 31, 36; 41, 46) der elektrischen Kontaktierung des anderen Bauelements (11, 12; 31, 36; 41, 46) dient.

## Beschreibung

### Stand der Technik

Die Erfindung betrifft eine Verbindungsanordnung nach dem Oberbegriff des Anspruchs 1.

Eine derartige Verbindungsanordnung ist aus der DE 101 30 618 B4 bekannt. Bei der bekannten Verbindungsanordnung wird ein insbesondere als elektrisches Bauelement ausgebildetes Bauteil durch eine Aufnahmeöffnung einer Leiterplatte gesteckt und auf der dem Bauelement gegenüberliegenden Seite der Leiterplatte mit einem Montageelement in Wirkverbindung gebracht. Das Montageelement besteht aus einer Formgedächtnislegierung, das unter dem Einfluss von Wärme eine kraft- und/oder formschlüssige Verbindung mit den Anschlusspartnern des Bauelementes eingeht.

Weitere Montageelemente unter Ausnützung des Formgedächtniseffektes sind aus der DE 101 08 956 A1 sowie der DE 101 09 222 A1 bekannt.

Konventionelle Klemmverbindungen zur elektrischen Kontaktierung zweier Bauelemente bestehen aus metallischen Rund- und Profildrähten, die sowohl in blanker, als auch in lackisolierter Form vorliegen. Der Rund- bzw. Profildraht wird unter Krafteinwirkung in eine Klemmgegenpassung eingedrückt. Hierdurch erfolgt im Falle lackierter Drähte eine Abisolierung, bevor die blanken Metalloberflächen in Kontakt miteinander geraten. Dies ist zwingend notwendig, da neben einer kraftschlüssigen Verbindung auch die elektrische Leitfähigkeit über das Klemmmedium (Draht) gegeben sein muss. Man spricht hier auch von einer so genannten kalten Kontaktierungstechnik, bei der kein Wärmeeintrag erfolgt. Die verwendeten Legierungen der Drähte sind in den meisten Anwendungsfällen auf Kupferbasis (zum Beispiel CuSn6, CuSn0.15, CuFe2P).

Beim Klemmen spielen die erzielten Restpresskräfte nach der Entlastung eine wichtige Rolle für die spätere elektrische Auslegung des Kontaktes. Die Restpresskraft (in der Klemmung zurückbleibende Presskraft) beeinflusst entscheidend den elektrischen Übergangswiderstand der Verbindung. Um eine hohe Restpresskraft im Fügeverbund zu gewährleisten, sind tendenziell sehr hohe Einpresskräfte erforderlich. Bei einer großen Anzahl von Einpressstellen, die gleichzeitig realisiert werden sollen, ist daher eine sehr hohe Presskraft erforderlich. Die Anzahl der gleichzeitig herzustellenden Verbindungen ist aufgrund der zulässigen Fügekräfte begrenzt, wodurch sich automatisch eine Limitierung hinsichtlich hochpoliger Anwendungen (große Anzahl an gleichzeitig erzeugten Klemmstellen) ergibt.

### Offenbarung der Erfindung

Ausgehend von dem dargestellten Stand der Technik liegt der Erfindung die Aufgabe zugrunde, eine Verbindungsanordnung nach dem Oberbegriff des Anspruchs 1 derart weiterzubilden, dass die zur Erzeugung von elektrischen Klemmverbindungen erforderlichen Kräfte reduziert werden. Diese Aufgabe wird bei einer Verbindungsanordnung mit den Merkmalen des Anspruchs 1 gelöst.

Vorteilhafte Weiterbildungen der erfindungsgemäßen Verbindungsanordnung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen.

In einer vorteilhaften Weiterbildung ist vorgesehen, dass das erste Bauelement aus der Formgedächtnislegierung besteht und wenigstens zwei Formveränderungsbereiche aufweist, die das zweite Bauelement an Kontaktbereichen kraft- bzw. formschlüssig kontaktieren. Durch diese Ausbildung wird eine Erhöhung der Kontaktierungskräfte ermöglicht, so dass eine besonders sichere Verbindung geschaffen wird.

Dabei ist es besonders vorteilhaft, wenn die beiden Formveränderungsbereiche am ersten Bauelement symmetrisch zueinander angeordnet sind. Dadurch wird ermöglicht, dass sich das erste Bauelement relativ einfach konstruktiv verwirklichen lässt und es werden weiterhin Querkräfte beim Kontaktieren vermieden.

Um die beiden Bauelemente vor dem Auftreten des Formgedächtniseffektes zueinander anzuordnen, ist es in einer weiteren Ausgestaltung der Erfindung vorgesehen, dass das zweite Bauelement eine Aufnahmeöffnung für das erste Bauelement im Bereich seiner Formveränderungsbereiche aufweist.

Alternativ hierzu ist es auch möglich, dass das erste Bauelement eine Aufnahme für das zweite Bauelement im Bereich seiner Formveränderungsbereiche ausbildet, in der das zweite Bauelement anordenbar ist.

Besonders vorteilhaft bei den beiden zuletzt genannten Weiterbildungen ist es hierbei, wenn die Anordnung der beiden Bauelemente zueinander zumindest in den Kontaktbereichen vor Eintreten des Formgedächtniseffektes mit Spiel ist. Dadurch können Fertigungstoleranzen an den Bauelementen einfach ausgeglichen werden.

Zur Erhöhung der Flächenpressung und somit zu einer Erhöhung der Verbindungssicherung wird vorgeschlagen, dass an einem der Bauelemente ein linien- oder punktförmiger Anlagebereich ausgebildet ist.

Eine derartige Erhöhung der Flächenpressung ist insbesondere dann vorteilhaft, wenn das zweite Bauelement ein eine Isolierung aufweisender Draht ist.

Um die Klemmkräfte darüber hinaus zusätzlich zu erhöhen, ist es weiterhin denkbar, dass beide Bauelemente zumindest teilweise aus einer Formgedächtnislegierung bestehen und, dass sich die Fügekräfte der Bauelemente unter Einfluss des Formgedächtniseffektes addieren.

Zum Hervorrufen des Formgedächtniseffektes ist es bei einem Verfahren zum Herstellen der Verbindungsanordnung vorgesehen, dass dieser durch die Einwirkung von Wärme und/oder mechanischer Spannung auf das wenigstens eine Bauelement aus der Formgedächtnislegierung erfolgt. Hierbei kann die Zuführung von Wärme beispielweise durch Wärmestrahlung, durch Stromfluss, durch Magnetfelder oder eine sonstige Art und Weise erfolgen. Dadurch lässt sich das Verfahren optimal an die Eigenschaften der konkret verwendeten Bauelemente anpassen. So ist es bei wärmeempfindlichen Bauelementen möglich, den Formgedächtniseffekt alleine durch Einwirken einer mechanischen Spannung zu erzeugen. Ebenso lässt sich bei mechanisch sensiblen Bauelementen den Formgedächtniseffekt alleine durch Einwirken von Wärme erzeugen. Bei sowohl mechanisch als auch thermisch sensiblen Bauelementen besteht die Möglichkeit, mechanische Spannungen und Wärme gleichzeitig anzuwenden, wobei die Parameter sowohl der mechanischen Spannung als auch der Wärme an die Belastbarkeit der Bauelemente anzupassen sind.

In einer weiteren Ausgestaltung der Erfindung ist es vorgesehen, dass zusätzlich zur Fügekraft der Bauelemente hervorgerufen durch den Formgedächtniseffekt das Fügen der Bauelemente unter Einwirkung einer zusätzlichen Fügekraft durch eine Montageeinrichtung erfolgt. Dieses Verfahren ist immer dann besonders vorteilhaft einsetzbar, wenn die Fügekraft, die durch den Formgedächtniseffekt hervorgerufen wird nicht ausreicht, um die gewünschte elektrische Kontaktierung zu bewirken, bzw. wenn die mechanische Kraft an Montageeinrichtungen zum Herstellen der elektrischen Kontaktierungen aus vorrichtungstechnischen Gründen beschränkt ist. Auch lassen sich bei Anwendung dieses Verfahrens entweder die Maschinenkosten reduzieren, da nicht mehr so große Fügekräfte erforderlich sind, oder aber die Taktzeiten reduzieren, oder aber bei bestehenden Maschinen zusätzliche Anwendungen ermöglichen.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1: eine erste erfindungsgemäße Verbindungsanordnung vor dem Auftreten des Formgedächtniseffektes im Querschnitt,
- Fig. 2: eine zweite erfindungsgemäße Verbindungsanordnung vor dem Auftreten des Formgedächtniseffektes im Längsschnitt,
- Fig. 3: eine dritte Verbindungsanordnung vor dem Auftreten des Form- gedächtniseffektes im Längsschnitt und
- Fig. 4: die dritte Verbindungsanordnung gemäß Fig. 3 nach dem Auftre- ten des Formgedächtniseffektes, ebenfalls im Längsschnitt.

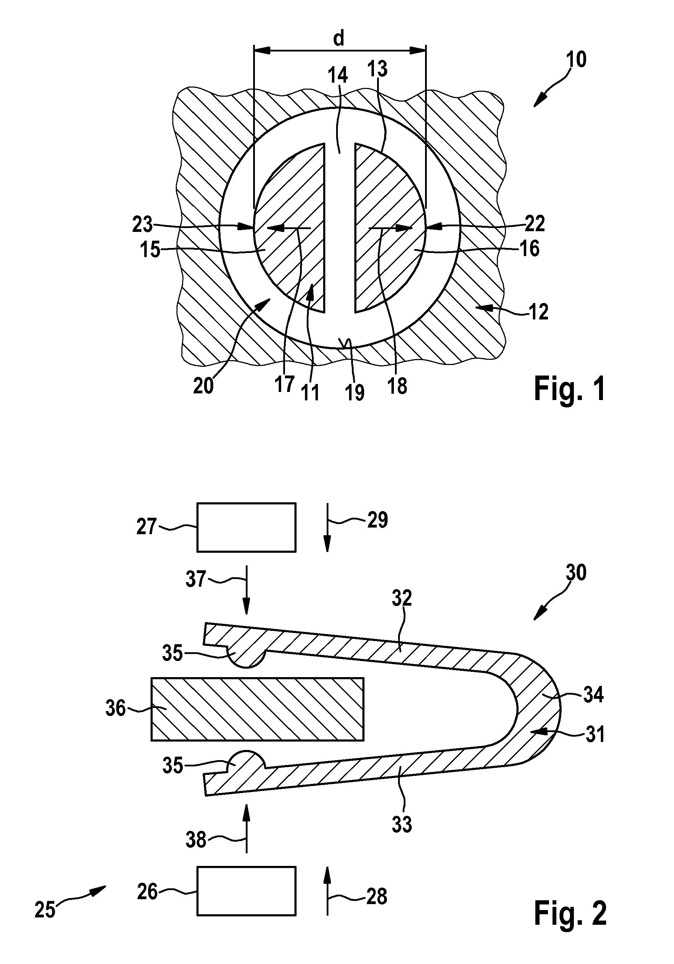

In der Fig. 1 ist eine erste Verbindungsanordnung 10 dargestellt. Die Verbindungsanordnung 10 dient der elektrischen Kontaktierung eines ersten Bauteils 11 mit einem zweiten Bauteil 12. Das erste Bauteil 11 ist beispielsweise als elektrischer Anschlussdraht 13 ausgebildet, der in seiner Längsachse geschlitzt ist. Im Bereich des Schlitzes 14 besteht der Anschlussdraht 13 aus zwei, zueinander symmetrisch angeordneten, im Querschnitt in etwa halbkreisförmigen Formveränderungsbereichen 15, 16. Als Material für den Anschlussdraht 13, zumindest im Bereich der Formveränderungsbereiche 15, 16, werden beispielhaft an sich bekannte Formgedächtnislegierung wie NiTi, CuAlNi oder CuZnAl genannt. Die beiden Formveränderungsbereiche 15, 16 bewegen sich unter dem Einfluss beispielsweise von Wärme in den durch die Pfeile 17 und 18 gekennzeichneten entgegengesetzten Richtungen.

Das zweite Bauteil 12, welches beispielsweise ein elektronisches Bauteil wie ein Widerstand, ein IC oder ähnliches ist, weist im Bereich der Verbindungsanordnung 10 eine Aufnahmeöffnung 19 auf. Die Aufnahmeöffnung 19 ist im Ausführungsbeispiel kreisförmig ausgebildet und weist einen Durchmesser auf, der größer ist als der Außendurchmesser d des Anschlussdrahtes 13 im Bereich der Formveränderungsbereiche 15, 16, solange der Formgedächtniseffekt an den Formveränderungsbereichen 15, 16 noch nicht auftritt. Insbesondere ist zwischen den Formveränderungsbereichen 15, 16 und der Aufnahmeöffnung 19 des zweiten Bauteils 12 noch ein Spalt 20 vorhanden.

Beim Auftreten des Formgedächtniseffektes (hervorgerufen durch Wärme und/oder mechanische Spannung auf das erste Bauteil 11) bewegen sich die beiden Formveränderungsbereiche 15, 16 des Anschlussdrahtes 13 in Richtung der Pfeile 17, 18, wobei linienförmige Anlagebereiche 22, 23 zwischen den Formveränderungsbereichen 15, 16 und der Wand der Aufnahmeöffnung 19 ausgebildet werden, über die der elektrische Strom durch die Bauteile 11, 12 fließen kann.

Bei der in der Fig. 2 dargestellten zweiten Verbindungsanordnung 30 ist das erste Bauteil 31 im Querschnitt zangen- bzw. bügelförmig ausgebildet. Es weist zwei aus einer Formgedächtnislegierung bestehende Formschenkel 32, 33 auf, die an einer gemeinsamen Basis 34 einstückig angeformt sind. An den beiden zueinander zugewandten Innenseiten der Formschenkel 32, 33 sind beispielsweise halbkugel- oder linienförmige Anlagebereiche 35 zur Erhöhung der Flächenpressung einstückig angeformt. Solange der Formgedächtniseffekt noch nicht auftritt, ist das zweite, hier plattenförmige Bauteil 36 vorzugsweise mit Spiel zwischen den Formschenkeln 32, 33 bzw. den Anlagebereichen 35 aufgenommen. Unter Einfluss des Formgedächtniseffektes bewegen sich die beiden Formschenkel 32, 33 in entgegengesetzter Richtung in Richtung der Pfeile 37, 38, wobei das zweite Bauteil 36 elektrisch kontaktiert wird.

Zusätzlich ist in der Fig. 2 noch eine Fügeeinrichtung 25 erkennbar, die Teil einer Montageeinrichtung ist. Die Fügeeinrichtung 25 umfasst zwei Spannbacken 26, 27, die in Richtung der Pfeile 28, 29 bewegt werden können, um eine zusätzliche Fügekraft auf die Formschenkel 32, 33 auszuüben. Das Einwirken der Spannbacken 26, 27 auf die Formschenkel 32, 33 kann entweder erst nach dem Auftreten des Formgedächtniseffektes erfolgen, oder aber es kann durch Erzeugen einer mechanischen Spannung in den Formschenkeln 32, 33 dazu verwendet werden, dass der Formgedächtniseffekt hervorgerufen wird. In diesem Fall kann beispielsweise auf die Einwirkung von Wärme verzichtet werden.

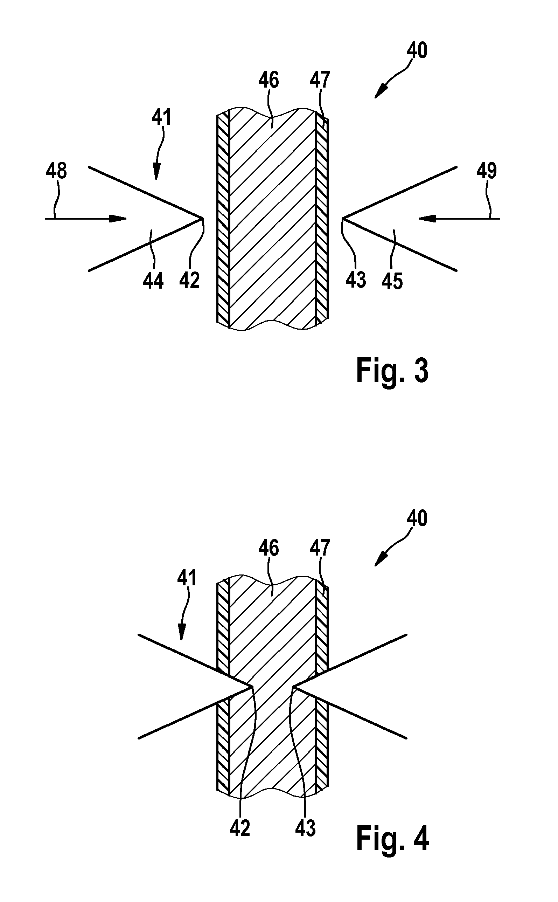

Bei der in den Fig. 3 und 4 dargestellten dritten erfindungsgemäßen Verbindungsanordnung 40 weist das erste Bauteil 41 zwei mit einer Spitze 42, 43 versehene Formveränderungsbereiche 44, 45 auf. Das zweite Bauteil 46 ist hier als Draht mit einer elektrischen Isolationsschicht 47 ausgebildet. Auch bei der dritten Verbindungsanordnung 40 ist das zweite Bauteil 46 zwischen den beiden Formveränderungsbereichen 44, 45 des ersten Bauteils 41 mit Spiel aufgenommen, solange der Formveränderungseffekt noch nicht eingetreten ist. Beim Eintreten des Formveränderungseffektes, welcher eine Bewegung der Formveränderungsbereiche 44, 45 in Richtung der entgegengesetzten Pfeile 48, 49 bewirkt, wird die Isolationsschicht 47 des zweiten Bauteils 46 durchstoßen, so dass eine elektrische Verbindung zwischen den Spitzen 42, 43 des ersten Bauteils 41 und dem zweiten Bauteil 46 geschaffen wird.

Ergänzend wird erwähnt, dass die Fügeeinrichtung 25 (ggf. in modifizierter Form) auch bei den beiden anderen Verbindungsanordnungen 10 und 40 angewandt werden kann. Ferner wurde die Erfindung am Beispiel des so genannten Einwegeeffektes beschrieben, bei der die Formveränderung bei Erwärmung eintritt. Die Erfindung ist jedoch sinngemäß auch unter Ausnutzung des so genanten Zweiwegeeffektes anwendbar.

Zuletzt bestand bei allen Ausführungsbeispielen lediglich das erste Bauteil aus einer Formgedächtnislegierung. Zur Verstärkung der Fügekräfte ist es auch möglich und denkbar, auch das jeweils zweite Bauteil, zumindest in den Fügebereichen, mit einer Formgedächtnislegierung auszubilden.

## Patentansprüche

1. Verbindungsanordnung (10; 30; 40), bestehend aus einem ersten Bauelement (11; 31; 41) und einem zweiten Bauelement (12; 36; 46), wobei wenigstens eines der Bauelemente (11, 12; 31, 36; 41, 46) zumindest teilweise aus einer Formgedächtnis-Legierung besteht und wobei zwischen den beiden Bauelementen (11, 12; 31, 36; 41, 46) eine kraft- bzw. formschlüssige Verbindung ausgebildet ist,
**dadurch gekennzeichnet,**
**dass** eines der Bauelemente (11, 12; 31, 36; 41, 46) der elektrischen Kontaktierung des anderen Bauelements (11, 12; 31, 36; 41, 46) dient.

2. Verbindungsanordnung nach Anspruch 1,
**dadurch gekennzeichnet,**
**dass** das erste Bauelement (11; 31; 41) aus der Formgedächtnis-Legierung besteht und wenigstens zwei Formveränderungsbereiche (15, 16; 32, 33; 44, 45) aufweist, die das zweite Bauelement (12; 36; 46) an Kontaktbereichen (22, 23; 35; 42, 43) kraft- bzw. formschlüssig kontaktieren.

3. Verbindungsanordnung nach Anspruch 2,
**dadurch gekennzeichnet,**
**dass** die beiden Formveränderungsbereiche (15, 16; 32, 33; 44, 45) am ersten Bauelement (11; 31; 41) symmetrisch zueinander angeordnet sind.

4. Verbindungsanordnung nach Anspruch 2 oder 3,
**dadurch gekennzeichnet,**
**dass** das zweite Bauelement (12) eine Aufnahmeöffnung (19) für das erste Bauelement (11) im Bereich seiner Formveränderungsbereiche (15, 16) aufweist, in der das erste Bauelement (11) vor Auftreten des Formgedächtniseffektes anordenbar ist.

5. Verbindungsanordnung nach Anspruch 2 oder 3,
**dadurch gekennzeichnet,**
**dass** das erste Bauelement (31; 41) vor Eintreten des Formgedächtniseffektes eine Aufnahme für das zweite Bauelement (36; 46) im Bereich seiner Formveränderungsbereiche (35; 44, 45) ausbildet, in der das zweite Bauelement (36; 46) anordenbar ist.

6. Verbindungsanordnung nach Anspruch 4 oder 5,
**dadurch gekennzeichnet,**
**dass** die Anordnung der beiden Bauelemente (11, 12; 31, 36; 41, 46) zueinander zumindest in den Formveränderungsbereiche (15, 16; 32, 33; 44, 45) vor Eintreten des Formgedächtniseffektes mit Spiel ist.

7. Verbindungsanordnung nach einem der Ansprüche 1 bis 6,
**dadurch gekennzeichnet,**
**dass** an zumindest einem der Bauelemente (31; 41) ein linien- oder punktförmiger Anlagebereich (35; 42, 43) ausgebildet ist.

8. Verbindungsanordnung nach einem der Ansprüche 2 bis 7,
**dadurch gekennzeichnet,**
**dass** das zweite Bauelement (46) ein eine Isolationsschicht (47) aufweisender Draht ist.

9. Verbindungsanordnung nach einem der Ansprüche 1 bis 8,
**dadurch gekennzeichnet,**
**dass** beide Bauelemente (11, 12; 31, 36; 41, 46) zumindest teilweise aus einer Formgedächtnis-Legierung bestehen und dass sich die Fügekräfte der Bauelemente (11, 12; 31, 36; 41, 46) unter Einfluss des Formgedächtniseffektes addieren.

10. Verbindungsanordnung nach einem der Ansprüche 1 bis 9,
**dadurch gekennzeichnet,**
**dass** die Verbindung im Bereich der Kontaktbereiche (22, 23; 35; 42, 43) nach dem Eintreten des Formgedächtniseffektes nicht mit zusätzlichen Fremdstoffen zur Ausbildung einer stoffschlüssigen Verbindung behandelt werden.

11. Verfahren zum Herstellen einer Verbindungsanordnung (10; 30; 40), insbesondere eine Verbindungsanordnung (10; 30; 40) nach einem der Ansprüche 1 bis 10, bei dem ein erstes Bauelement (11; 31; 41) mit einem zweiten Bauelement (12; 36; 46) verbunden wird, wobei wenigstens eines der Bauelemente (11, 12; 31, 36; 41, 46) zumindest teilweise aus einer Formgedächtnis-Legierung besteht, wobei zwischen den beiden Bauelementen (11, 12; 31, 36; 41, 46) eine kraft- bzw. formschlüssige Verbindung ausgebildet wird und wobei eines der Bauelemente (11, 12; 31, 36; 41, 46) der elektrischen Kontaktierung des anderen Bauelements (11, 12; 31, 36; 41, 46) dient,
**dadurch gekennzeichnet,**
**dass** der Formgedächtniseffekt durch die Einwirkung von Wärme und/oder einer mechanischen Spannung auf das wenigstens eine Bauelement (11, 12; 31, 36; 41, 46) aus der Formgedächtnis-Legierung hervorgerufen wird.

12. Verfahren nach Anspruch 11,
**dadurch gekennzeichnet,**
**dass** zusätzlich zur Wärme und/oder mechanischen Spannung zum Hervorrufen des Formgedächtniseffektes auf wenigstens eines der Bauelemente (11, 12; 31, 36; 41, 46) eine zusätzliche Fügekraft mittels einer Montageeinrichtung (25) ausgeübt wird.
